# EUROPÄISCHE PATENTSCHRIFT

(11) **EP 2 603 808 B1**
(45) Veröffentlichungstag und Bekanntmachung des Hinweises auf die Patenterteilung: **15.04.2020**
(21) Anmeldenummer: 11749135.7
(22) Anmeldetag: 04.08.2011
(51) Int. Cl.: G01R 31/36, G01R 31/3832, G01R 31/382

(54) **VERFAHREN ZUR BESTIMMUNG EINES LADEZUSTANDES EINER BATTERIE**
METHOD FOR DETERMINING A CHARGE STATE OF A BATTERY
PROCÉDÉ DE DÉTERMINATION DE L'ÉTAT DE CHARGE D'UNE BATTERIE

(30) Priorität: 13.08.2010 DE 102010039326
(43) Veröffentlichungstag der Anmeldung: 19.06.2013
(73) Patentinhaber: Robert Bosch GmbH, 70442 Stuttgart (DE); Samsung SDI Co., Ltd., Yongin-si Gyeonggi-do 446-577 (KR)
(72) Erfinder: KRIEG, Berengar, 70839 Gerlingen (DE)
(74) Vertreter: Bee, Joachim
(86) Internationale Anmeldenummer: PCT/EP2011/063433
(87) Internationale Veröffentlichungsnummer: WO 2012/019960

(56) Entgegenhaltungen:
- EP-A2- 0 794 438
- WO-A1-2005/111642
- WO-A1-2009/096565
- DE-A1- 19 912 300
- DATABASE EPODOC [Online] EUROPEAN PATENT OFFICE, THE HAGUE, NL; 13. September 2005 (2005-09-13), YAZAKI CORP: "BATTERY CONDITION DETECTOR", XP002664660, Database accession no. JP20050264811 -& JP 2007 078443 A (YAZAKI CORP) 29. März 2007 (2007-03-29)

## Beschreibung

Die vorliegende Erfindung betrifft ein Verfahren zur Bestimmung eines Ladezustandes einer Batterie, gemäß Anspruch 1, eine Batterie, die dazu ausgebildet ist, das erfindungsgemäße Verfahren auszuführen, sowie ein Kraftfahrzeug mit der erfindungsgemäßen Batterie.

### Stand der Technik

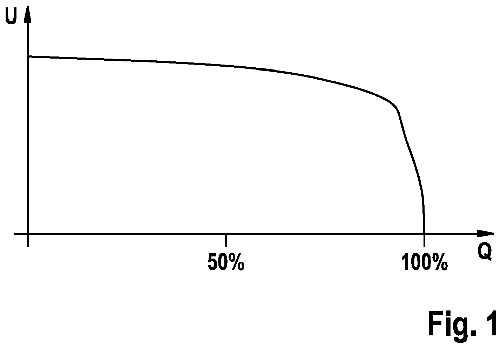

Aus dem Stand der Technik sind verschiedene Verfahren zur Bestimmung eines Ladezustandes einer Batterie bekannt. Bei einem dieser bekannten Verfahren wird die Batteriezustandserkennung dadurch erreicht, dass die Spannung der nicht belasteten Batterie, auch OCV (open circuit voltage) genannt, gemessen wird. Teilweise wird diese zusätzlich mit der Spannung unter Belastung verglichen. Das Verfahren ist bei einer steilen Abhängigkeit des Ladezustandes von der Spannung der nicht belasteten Batterie relativ zuverlässig, ist aber ungeeignet bei Batteriesystemen, welche einen flachen derartigen Verlauf aufweisen, wie dies in Figur 1 am Beispiel einer Batterie auf Lithium-Eisen-Phosphat-Basis dargestellt ist.

Bei einem weiteren Verfahren zur Bestimmung des Ladezustandes einer Batterie wird ein durch die Batterie fließender Batteriestrom gemessen und über die Zeit integriert. Ein solches Verfahren wird zum Beispiel bei Batteriesystemen eingesetzt, welche während der Nichtnutzung vom Verbrauchernetz abgetrennt werden können. Ein solcher inaktiver Betriebszustand kann dann vorliegen, wenn eine übergeordnete Steuereinheit, beispielsweise eine Motorsteuereinheit in einem Kraftfahrzeug, ausgeschaltet ist. Muss vom Batteriesystem eine gewisse Ruhestromanforderung abgedeckt werden, kann in einem solchen inaktiven Betriebszustand der Batterieelektronik die Batterie merklich entladen werden. Zur hinreichend genauen Ladezustandsbestimmung müsste eine die zeitliche Integration des Batteriestroms ausführende Komponente dauerhaft aktiv sein, was zu einer erhöhten Entladung der Batterie während des inaktiven Betriebszustandes führen würde.

Aus der JP2007078443 A ist eine Vorrichtung bekannt, welche den in beziehungsweise aus einer Batterie fließenden Ladestrom beziehungsweise Entladestrom über einen Hall-IC misst. Der Hall-IC generiert ein "Aufweck-Signal" und übermittelt dieses an eine CPU, wenn der Stromwert von Lade- und/oder Entladestrom eine vorbestimmte Schwelle überschreitet. Die CPU wechselt daraufhin in einen "active-mode" und führt eine Batteriezustandsüberprüfung, insbesondere eine Ladezustandsprüfung der Batterie aus, welche auf dem Lade- bzw. Entladestrom der Batterie basiert sowie von der Spannung an den Batterieterminals abhängt. Ist die Batteriezustandsprüfung beendet und wird das "Aufweck-Signal" nicht weiter übermittelt, geht die CPU in einen "Sleep-Mode" über, aus dem sie erst wieder erwacht, wenn die vorbestimmte Schwelle erneut überschritten wird.

### Offenbarung der Erfindung

Erfindungsgemäß wird ein Verfahren zur Bestimmung eines Ladezustandes einer Batterie mit einer Batteriemanagementeinheit und einer der Batteriemanagementeinheit übergeordneten Steuereinheit zur Verfügung gestellt,
wobei die Batteriemanagementeinheit zur Bestimmung des Ladezustandes in drei Betriebszuständen betrieben werden kann,
wobei in einem ersten Betriebszustand der Batteriemanagementeinheit ein Batteriestrom durch die Batteriemanagementeinheit regelmäßig erfasst wird,
wobei in einem zweiten Betriebszustand Informationen über den Ladezustand der Batterie durch die Batteriemanagementeinheit gesammelt werden, insbesondere der Ladezustand der Batterie bestimmt wird,
und wobei mindestens eine in einem dritten Betriebszustand ausführbare Funktion, die mindestens eine Kommunikationsfunktion zu der übergeordneten Steuereinheit umfasst, gesperrt wird,
wobei in dem dritten Betriebszustand, welcher einem Vollbetriebszustand entspricht, durch die Batteriemanagementeinheit der Batteriestrom erfasst wird und der Ladezustand der Batterie bestimmt wird und mit der eingeschalteten übergeordneten Steuereinheit kommuniziert wird,
wobei die Batteriemanagementeinheit vom ersten Betriebszustand in den zweiten Betriebszustand wechselt, wenn der Batteriestrom einen vorbestimmten Stromschwellenwert überschreitet,
wobei die Batteriemanagementeinheit durch die übergeordnete Steuereinheit in den dritten Betriebszustand versetzt wird, insbesondere durch das Übersenden eines Wecksignals.

Unter dem Begriff Batteriemanagementeinheit fallen vor allem
Batteriemanagementsysteme, welche bei höherwertigen Batterien zum Beispiel für Traktionsnetze in Hybridfahrzeugen eingesetzt werden. Unter dem Begriff Batteriemanagementeinheit fallen jedoch auch Batteriesensorsysteme in bestimmten Batterien, welche beispielsweise bei Start-Stopp-Anwendungen in Kraftfahrzeugen eingesetzt werden. Auch mit solchen Batteriesensorsystemen kann das erfindungsgemäße Verfahren ausgeführt werden, so lange sie dazu ausgelegt sind, Informationen über den Ladezustand der Batterie zu sammeln.

Das erfindungsgemäße Verfahren stellt einen Aktivierungsmechanismus der Batteriemanagementeinheit dar. Im Unterschied zu bereits bekannten Aktivierungsmechanismen, welche die Batteriemanagementeinheit durch ein über ein Kommunikationsprotokoll oder eine Hardware-Leitung gesendetes Aufwecksignal in einen aktiven Betriebszustand versetzen, sieht das erfindungsgemäße Verfahren einen Aufweckmechanismus vor, welcher batterieintern verläuft.

Das erfindungsgemäße Verfahren hat den Vorteil, dass die Entladung der Batterie in dem ersten Betriebszustand gering gehalten wird. Der erste Betriebszustand entspricht hierbei typischerweise einem inaktiven Betriebszustand, in welchem das Batteriesystem nicht oder nur in geringem Maße genutzt wird, aber dennoch an das Verbrauchernetz angeschlossen bleibt, entweder weil auf eine Trennung des Batteriesystems von dem Verbrauchernetz verzichtet wird oder weil eine solche nicht erforderlich ist, da die Systemspannung ausreichend niedrig ist.

In dem ersten Betriebszustand ist es normalerweise nicht erforderlich, Informationen über den Ladezustand der Batterie zu sammeln. Bevorzugt werden in dem ersten Betriebszustand zusätzlich zur Erfassung des Batteriestromes keine Funktionen ausgeübt. Somit ist der erste Betriebszustand der energiesparsamste Betriebszustand der Batteriemanagementeinheit.

In dem zweiten Betriebszustand können Informationen über den Ladezustand der Batterie gesammelt werden, indem der Batteriestrom über die Zeit integriert wird. Des Weiteren kann die Kommunikation zu einer der Batteriemanagementeinheit übergeordneten Steuereinheit im zweiten Betriebszustand unterbunden werden, während sie im Vollbetriebszustand aktiviert ist.

Die übergeordnete Steuereinheit kann jedoch die Batteriemanagementeinheit in den dritten Betriebszustand versetzen, insbesondere durch das Übersenden eines Wecksignals. Dies kann beispielsweise auf einem Controller Area Network (CAN)-Bus erfolgen.

Die Batteriemanagementeinheit kann im ersten Betriebszustand mit einer niedrigeren Taktfrequenz betrieben werden als im zweiten Betriebszustand. Sogar kann die Elektronik bis auf eine kontinuierlich arbeitende, ungetaktete Schaltung, die den Batteriestrom auf Überschreitung eines Schwellwerts überwacht, deaktiviert bleiben. Ebenso kann sie im zweiten Betriebszustand mit einer niedrigeren Taktfrequenz betrieben werden als im dritten Betriebszustand, welcher normalerweise dem Vollbetrieb entspricht.

Die Batteriemanagementeinheit kann von dem zweiten in den ersten Betriebszustand zurückwechseln, wenn der Batteriestrom den vorbestimmten Stromschwellenwert wiederum unterschreitet.

Ein weiterer Aspekt der Erfindung betrifft eine Batterie, bevorzugt eine Lithium-Ionen-Batterie, welche eine Batteriemanagementeinheit mit einem Stromsensor umfasst. Die Batteriemanagementeinheit ist dazu ausgebildet, das erfindungsgemäße Verfahren auszuführen.

Bevorzugt ist, dass der Stromsensor ein passives Bauelement, insbesondere einen Shunt-Widerstand umfasst. Dies hat den Vorteil, dass die Batteriemanagementeinheit auch in dem ersten Betriebszustand mit geringem Strombedarf betrieben werden kann und die zur Ausführung des Verfahrens erforderlichen Strommessungen energiesparsam ausgewertet werden können. Die Überwachung des Batteriestromes auf Überschreiten des vorbestimmten Stromschwellenwertes (beispielsweise 0,5 bis 2 A) kann beispielsweise durch einen Komparator erfolgen, welcher eine ausreichend geringe Stromaufnahme von einigen µA erfordert. Dabei ist der Strom sowohl in Entlade- als auch in Laderichtung zu überwachen.

Ein weiterer Aspekt der Erfindung betrifft ein Kraftfahrzeug, welches die erfindungsgemäße Batterie umfasst.

### Zeichnungen

Ausführungsbeispiele der Erfindung werden anhand der Zeichnungen und der nachfolgenden Beschreibung näher erläutert. Es zeigen:
Figur 1 einen Verlauf der Spannung einer nicht belasteten Batterie auf Lithium-Eisen-Phosphat-Basis in Abhängigkeit des Ladezustandes der Batterie,
Figur 2 verschiedene Betriebszustände eines Kraftfahrzeugs,
Figur 3 verschiedene Betriebszustände einer Batteriemanagementeinheit gemäß einem Ausführungsbeispiel der Erfindung, und
Figur 4 ein Flussdiagramm des erfindungsgemäßen Verfahrens zur Bestimmung des Ladezustandes einer Batterie gemäß einem Ausführungsbeispiel.

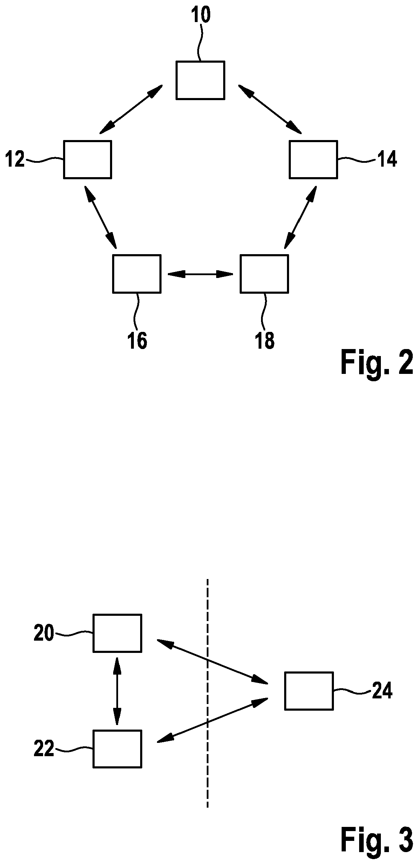

Figur 2 zeigt fünf mögliche Betriebszustände in einem nicht hybridisierten Kraftfahrzeug, welches eine Batterie (Auto- oder Starterbatterie) umfasst.

Ein erster Betriebszustand 10 entspricht einem Parkzustand des Kraftfahrzeugs, bei welchem die Batterie eine Ruhestromanforderung von typischerweise 10 bis 60 mA bei einer Standzeit von bis zu sechs Wochen abdecken muss.

Ein zweiter Betriebszustand des Kraftfahrzeugs 12 entspricht der Entladung der Batterie bei ausgeschalteter Zündung und damit auch ausgeschalteter übergeordneter Steuereinheit, beispielsweise Motorsteuereinheit, wobei Verbraucher wie Innenraumbeleuchtung, Fahrzeugbeleuchtung, Warnblinker oder Radio einen Strom von einigen 100 mA bis mehreren A in einem Zeitraum von wenigen Minuten bis zu mehreren Stunden verbrauchen.

Ein dritter Betriebszustand des Kraftfahrzeugs 14 entspricht der Entladung der Batterie bei eingeschalteter Zündung oder anderweitig eingeschalteter übergeordneter Steuereinheit, wobei ein Strom von einigen 100 mA bis mehreren A über wenige Sekunden bis mehreren Minuten fließen kann.

Ein vierter Betriebszustand des Kraftfahrzeugs 16 entspricht der Ladung der Batterie bei eingeschalteter Zündung und eingeschalteter übergeordneter Steuereinheit bei laufendem Verbrennungsmotor.

Ein fünfter Betriebszustand des Kraftfahrzeugs 18 entspricht schließlich der Ladung der Batterie bei ausgeschalteter Zündung und ausgeschalteter übergeordneter Steuereinheit, beispielsweise wenn die Ladung durch ein externes Ladegerät erfolgt.

Zwischen den einzelnen Betriebszuständen 10 bis 18 ist ein Wechsel jederzeit möglich (in Figur 2 nur schematisch dargestellt). Eine Bestimmung des Ladezustandes der Batterie ist gemäß dem Stand der Technik mit vertretbarem Energieverbrauch nur in den Betriebszuständen 14 und 16 möglich, da in diesen Zuständen die übergeordnete Steuereinheit eingeschaltet ist und sich das Kraftfahrzeug in keinem Energiesparmodus befindet. Dagegen ist eine Bestimmung des Ladezustandes der Batterie mit aus dem Stand der Technik bekannten Batteriemanagementeinheiten in den Betriebszuständen 10, 12 und 18 nicht möglich, da diese eine Leistungsaufnahme von bis zu 20 W im Betrieb aufweisen und damit eine zu hohe Belastung der Batteriekapazität verursachen.

Figur 3 zeigt verschiedene Betriebszustände einer Batteriemanagementeinheit gemäß einem Ausführungsbeispiel der Erfindung.

In einem ersten Betriebszustand der Batteriemanagementeinheit 20 befindet sich diese in einem Energiesparmodus. Es wird ein Batteriestrom gemessen und mit einem Stromschwellenwert verglichen. Darüber hinaus führt die Batteriemanagementeinheit nur wenige oder gar keine Funktionen aus. Eine Kommunikation zur übergeordneten Steuereinheit wird unterdrückt.

In einem zweiten Betriebszustand der Batteriemanagementeinheit 22 befindet sich diese ebenso in einem Energiesparmodus. Der Batteriestrom wird gemessen und über die Zeit integriert, um den Ladungszustand der Batterie zu bestimmen. Darüber hinaus führt die Batteriemanagementeinheit nur wenige oder gar keine Funktionen aus. Gegebenenfalls wird eine Batteriealterung berechnet. Auf eine Leistungsprädiktion wird verzichtet. Eine Kommunikation zur übergeordneten Steuereinheit wird auch hier unterdrückt.

Der erste oder zweite Betriebszustand der Batteriemanagementeinheit 20 beziehungsweise 22 wird eingenommen, wenn die übergeordnete Steuereinheit des Kraftfahrzeugs ausgeschaltet ist, also in einem der Betriebszustände 10, 12 und 18 des Kraftfahrzeugs. Wechselt das Kraftfahrzeug in einen der Betriebszustände 14 oder 16, in welchem die übergeordnete Steuereinheit eingeschaltet ist, kann diese die Batteriemanagementeinheit durch Aussendung eines Wecksignals auf einem CAN-Bus, Local Interconnect Network (LIN)-Bus, anderweitig ausgeprägten Bussystem oder einer Hardware-Weckleitung, an welchem beziehungsweise an welcher beide Komponenten angeschlossen sind, aufwecken und in einen dritten Betriebszustand 24 versetzen, welcher einem Vollbetriebsmodus entspricht. Auch eine Rückkehr vom dritten Betriebszustand 24 in den ersten oder zweiten Betriebszustand der Batteriemanagementeinheit 20 beziehungsweise 22 ist möglich.

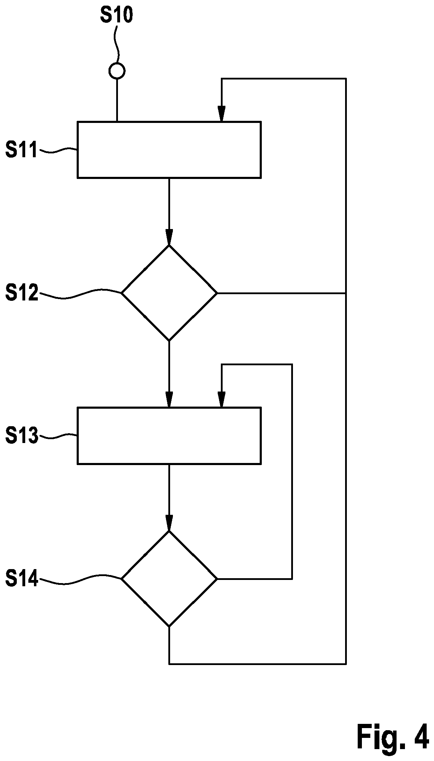

Figur 4 zeigt ein Ausführungsbeispiel eines erfindungsgemäßen Verfahrens zur Bestimmung eines Ladezustands einer Batterie. Das Verfahren startet in Schritt S10, wenn sich das Kraftfahrzeug in einem der Betriebszustände 10, 12 oder 18 befindet und somit die der Batterie übergeordnete Steuereinheit ausgeschaltet ist. Die Batteriemanagementeinheit der Batterie befindet sich dabei in dem ersten Betriebszustand 20, in welchem die Batteriemanagementeinheit lediglich den Batteriestrom erfasst (S11), darüber hinaus jedoch keine Funktionen ausübt.

Im Schritt S12 wird der erfasste Batteriestrom mit einem vorbestimmten Stromschwellenwert verglichen. Wenn der erfasste Batteriestrom nicht größer als der vorbestimmte Stromschwellenwert ist, wird zum Beginn des Verfahrens in Schritt S11 zurückverzweigt, andernfalls wird im Schritt S13 in den zweiten Betriebszustand der Batteriemanagementeinheit 22 gewechselt, in welchem der Batteriestrom über die Zeit integriert wird, um dadurch den Ladezustand der Batterie zu bestimmen. Die Batteriemanagementeinheit ist auch in ihrem zweiten Betriebszustand 22 im Wesentlichen inaktiv, das heißt, sie bestimmt lediglich den Ladezustand der Batterie, führt aber weitere Funktionen nicht oder nur in geringem Umfang aus. Insbesondere ist eine Kommunikation mit der übergeordneten Steuereinheit in dem zweiten Betriebszustand der Batteriemanagementeinheit 22 gesperrt, beziehungsweise kann lediglich durch die übergeordnete Steuereinheit selbst aufgenommen werden.

Im Schritt S14 wird der erfasste Batteriestrom mit dem vorbestimmten Stromschwellenwert verglichen. Wenn der erfasste Batteriestrom nicht kleiner als der vorbestimmte Stromschwellenwert ist, wird weiterhin der Ladezustand der Batterie bestimmt (S13), andernfalls wird wieder in den ersten Betriebszustand der Batteriemanagementeinheit 20 gewechselt (S11).

Der Fehler, welcher dadurch entsteht, dass in dem ersten Betriebszustand der Batteriemanagementeinheit 20 keine Bestimmung des Ladezustands erfolgt, kann durch die Dauer der Phase, in welcher sich die Batteriemanagementeinheit in dem ersten Betriebszustand 20 befindet, abgeschätzt werden, da der in diesem Betriebszustand fließende Batteriestrom relativ konstant ist. Beispielsweise kann ein Maximalfehler als das Produkt von Stromschwellenwert und Dauer der genannten Phase berechnet werden.

## Patentansprüche

1. Verfahren zur Bestimmung eines Ladezustandes einer Batterie mit einer Batteriemanagementeinheit und einer der Batteriemanagementeinheit übergeordneten Steuereinheit, wobei die Batteriemanagementeinheit zur Bestimmung des Ladezustandes in drei Betriebszuständen betrieben werden kann,
- wobei in einem ersten Betriebszustand (20) der Batteriemanagementeinheit ein Batteriestrom durch die Batteriemanagementeinheit regelmäßig erfasst wird (S11),
- wobei in einem zweiten Betriebszustand (22) Informationen über den Ladezustand der Batterie durch die Batteriemanagementeinheit gesammelt werden (S13), wobei der Ladezustand der Batterie bestimmt wird, und wobei mindestens eine in einem dritten Betriebszustand (24) ausführbare Funktion, die mindestens eine Kommunikationsfunktion zu der übergeordneten Steuereinheit umfasst, gesperrt wird,
- wobei in dem dritten Betriebszustand (24), welcher einem Vollbetriebszustand entspricht, durch die Batteriemanagementeinheit der Batteriestrom erfasst wird und der Ladezustand der Batterie bestimmt wird und mit der eingeschalteten übergeordneten Steuereinheit kommuniziert wird,
- wobei die Batteriemanagementeinheit vom ersten Betriebszustand (20) in den zweiten Betriebszustand (22) wechselt (S13), wenn der Batteriestrom einen vorbestimmten Stromschwellenwert überschreitet (S12),
- wobei die Batteriemanagementeinheit durch die übergeordnete Steuereinheit in den dritten Betriebszustand (24) versetzt wird, insbesondere durch das Übersenden eines Wecksignals.

2. Verfahren nach Anspruch 1, wobei in dem ersten Betriebszustand (20) keine Informationen über den Ladezustand der Batterie gesammelt werden.

3. Verfahren nach Anspruch 1 oder 2, wobei in dem zweiten Betriebszustand (22) Informationen über den Ladezustand der Batterie gesammelt werden (S13), indem der Batteriestrom über die Zeit integriert wird.

4. Verfahren nach einem der vorangehenden Ansprüche, wobei die Batteriemanagementeinheit in dem ersten Betriebszustand (20) zusätzlich zur Erfassung des Batteriestromes keine Funktionen ausübt.

5. Verfahren nach einem der vorangehenden Ansprüche, wobei die Batteriemanagementeinheit im ersten Betriebszustand (20) mit einer niedrigeren Taktfrequenz betrieben wird als im zweiten Betriebszustand (22) und/oder im zweiten Betriebszustand (22) mit einer niedrigeren Taktfrequenz betrieben wird als im dritten Betriebszustand (24).

6. Verfahren nach einem der vorangehenden Ansprüche, wobei die Batteriemanagementeinheit von dem zweiten (22) in den ersten Betriebszustand (20) wechselt (S14), wenn der Batteriestrom den vorbestimmten Stromschwellenwert unterschreitet (S14).

7. Batterie umfassend eine Batteriemanagementeinheit mit einem Stromsensor, **dadurch gekennzeichnet, dass** die Batteriemanagementeinheit dazu ausgebildet ist, ein Verfahren nach einem der vorangehenden Ansprüche auszuführen.

8. Batterie nach Anspruch 7, wobei der Stromsensor ein passives Bauelement, insbesondere einen Shunt-Widerstand, umfasst.

9. Kraftfahrzeug mit einer Batterie nach einem der Ansprüche 7 oder 8.

## Claims

1. Method for determining a state-of-charge of a battery having a battery management unit and a control unit that is superimposed on the battery management unit, wherein the battery management unit can be operated in three operating modes for determining the state-of-charge,
- wherein in a first operating mode (20) of the battery management unit a battery current is regularly sensed by means of the battery management unit (S11),
- wherein in a second operating mode (22) information regarding the state-of-charge of the battery is collected by the battery management unit (S13), wherein the state-of-charge of the battery is determined, and wherein at least one function, which can be performed in a third operating mode (24) and comprises at least one communication function to the superimposed control unit, is disabled,
- wherein in the third operating mode (24), which corresponds to a fully operating mode, the battery current is sensed and the state-of-charge of the battery is determined and is communicated with the switched-on superimposed control unit by means of the battery management unit,
- wherein the battery management unit switches from the first operating mode (20) into the second operating mode (22) (S13) if the battery current exceeds a predetermined current threshold value (S12),
- wherein the battery management unit is switched into the third operating mode (24) by the superimposed control unit, in particular by means of transmitting a wakeup signal.

2. Method according to Claim 1, wherein information regarding the state-of-charge of the battery is not collected in the first operating mode (20).

3. Method according to Claim 1 or 2, wherein information regarding the state-of-charge of the battery is collected in the second operating mode (22) (S13) by integrating the battery current over time.

4. Method according to any one of the preceding claims, wherein in the first operating mode (20) the battery management unit does not perform any functions in addition to sensing the battery current.

5. Method according to any one of the preceding claims, wherein the battery management unit is operated in the first operating mode (20) at a lower pulse frequency than in the second operating mode (22) and/or is operated in the second operating mode (22) at a lower pulse frequency than in the third operating mode (24).

6. Method according to any one of the preceding claims, wherein the battery management unit switches from the second operating mode (22) into the first operating mode (20) (S14) if the battery current is below the predetermined current threshold value (S14).

7. Battery comprising a battery management unit having a current sensor, **characterized in that** the battery management unit is embodied for the purpose of performing a method according to any one of the preceding claims.

8. Battery according to Claim 7, wherein the current sensor comprises a passive component, in particular a shunt resistor.

9. Motor vehicle having a battery according to either one of Claims 7 and 8.

## Revendications

1. Procédé de détermination d'un état de charge d'une batterie comprenant une unité de gestion de batterie et une unité de commande à laquelle est subordonnée l'unité de gestion de batterie, l'unité de gestion de batterie pouvant être utilisée dans trois états opérationnels pour déterminer l'état de charge,
- dans un premier état opérationnel (20) de l'unité de gestion de batterie, un courant de batterie étant régulièrement acquis (S11) par l'unité de gestion de batterie,
- dans un deuxième état opérationnel (22), des informations à propos de l'état de charge de la batterie étant collectées (S13) par l'unité de gestion de batterie,
l'état de charge de la batterie étant déterminé et au moins une fonction qui peut être exécutée dans un troisième état opérationnel (24), laquelle comprend au moins une fonction de communication vers l'unité de commande de niveau supérieur, étant bloquée,
- dans le troisième état opérationnel (24), lequel correspond à un état opérationnel complet, le courant de batterie étant acquis par l'unité de gestion de batterie et l'état de charge de la batterie étant déterminé et une communication ayant lieu avec l'unité de commande de niveau supérieur mise en circuit,
- l'unité de gestion de batterie basculant (S13) du premier état opérationnel (20) au deuxième état opérationnel (22) lorsque le courant de batterie dépasse (S12) une valeur de seuil de courant prédéterminée,
- l'unité de gestion de batterie étant amenée dans le troisième état opérationnel (24) par l'unité de commande de niveau supérieur, notamment par l'envoi d'un signal de réveil.

2. Procédé selon la revendication 1, aucune information à propos de l'état de charge de la batterie n'étant collectée dans le premier état opérationnel (20).

3. Procédé selon la revendication 1 ou 2, des informations à propos de l'état de charge de la batterie étant collectées (S13) dans le deuxième état opérationnel (22) par intégration dans le temps du courant de batterie.

4. Procédé selon l'une des revendications précédentes, l'unité de gestion de batterie dans le premier état opérationnel (20) n'exerçant aucune fonction en plus de l'acquisition du courant de batterie.

5. Procédé selon l'une des revendications précédentes, l'unité de gestion de batterie dans le premier état opérationnel (20) fonctionnant avec une fréquence d'horloge plus faible que dans le deuxième état opérationnel (22) et/ou fonctionnant dans le deuxième état opérationnel (22) avec une fréquence d'horloge plus faible que dans le troisième état opérationnel (24).

6. Procédé selon l'une des revendications précédentes, l'unité de gestion de batterie basculant (S14) du deuxième (22) au premier état opérationnel (20) lorsque le courant de batterie devient inférieur (S14) à la valeur de seuil de courant prédéterminée.

7. Batterie comprenant une unité de gestion de batterie dotée d'un capteur de courant, **caractérisée en ce que** l'unité de gestion de batterie est conçue pour mettre en œuvre un procédé selon l'une des revendications précédentes.

8. Batterie selon la revendication 7, le capteur de courant comportant un composant passif, notamment une résistance shunt.

9. Véhicule automobile comprenant une batterie selon l'une des revendications 7 ou 8.
